Europäisches Patentamt

European Patent Office

Office européen des brevets

(19)

(11) Publication number: **0 171 186**
A1

(12) **EUROPEAN PATENT APPLICATION**

(21) Application number: 85304819.7

(51) Int. Cl.⁴: **H 01 L 21/306**

(22) Date of filing: 05.07.85

(30) Priority: 05.07.84 JP 139620/84

(43) Date of publication of application: 12.02.86
Bulletin 86/7

(84) Designated Contracting States: DE FR GB

(71) Applicant: NEC CORPORATION, 33-1, Shiba 5-chome, Minato-ku, Tokyo 108 (JP)

(72) Inventor: Tomita, Yutaka, c/o NEC Corporation 33-1, Shiba 5-chome, Minato-ku Tokyo (JP)

(74) Representative: Cropp, John Anthony David et al, MATHYS & SQUIRE 10 Fleet Street, London, EC4Y 1AY (GB)

(54) **Method of manufacturing a semiconductor device involving the etching of a polycrystalline silicon layer.**

(57) It is known to manufacture a semiconductor device utilizing a polycrystalline silicon layer; however, since the polycrystalline silicon layer has hydrophobic nature, the precise processing thereof is quite difficult if the processing includes a wet etching procedure: inpurity deposits are observed after washing and drying procedures following the removal of a phosphosilicate glass layer formed during diffusing phosphorus or boron in the polycrystalline silicon layer and detrimental to the subsequent process, in particular, to the etching of the polycrystalline silicon layer. The problem can be solved by converting the hydrophobic surface of the silicon layer to a hydrophilic one by treating the surface with a strong oxidizing solution such as an aqueous solution of nitric acid or hydrogen peroxide. This treatment causes the formation of silanol groups on the surface of the polycrystalline silicon layer so that the formation of impurity deposits thereon can effectively be eliminated.

\

# TITLE MODIFIED
## see front page

Method of Manufacturing Semiconductor Devices

Field of the Invention

The present invention relates to a method of manufacturing semiconductor devices having a polycrystalline silicon layer in particular to a treatment carried out after diffusing phosphorus or boron into the polycrystalline silicon layer in a high concentration.

Description of the Prior Art

Up to now, the semiconductor manufacturing process technique has remarkably been progressed and it has been directed to accomplish a fine processing technique and a high density mounting technique for integrated circuit (IC) semiconductor devices.

A polycrystalline silicon gate type field effect transistor (FET) is widely utilized because it has a structure suitable for fine processing. This polycrystalline silicon gate structure is, in general, obtained when the source and drain areas are produced by forming a silicon gate of polycrystalline silicon layer on the oxide gate film on the channel area and then diffusing boron (B) or phosphorus (P) utilizing the silicon gate as the mask to form source and

1

drain regions. Such an FET structure provides a lot of advantages such that the area occupied and undesired capacity component are reduced since the structure is a self align one and that it may serve as a memory by charging the silicon gate.

However, the electrical resistance of the polycrystalline silicon itself is quite high so that the operating speed of a device utilizing the silicon gate is also very low. Then, in order to reduce the electrical resistance of the polycrystalline silicon layer and to improve operating speed thereof, it is, in general, needed to incorporate a conductivity improving element such as phosphorus or boron in the polycrystalline silicon layer in a high concentration.

A conventional method for preparing a polycrystalline silicon having a low electrical resistance comprises diffusing phosphorus or boron in the polycrystalline silicon layer, removing phosphosilicate glass layer or borosilicate glass layer of low quality having a high phosphorus or boron concentration and formed, during the diffusion process, on the surface of the silicon layer, by immersing it in hydrofluoric acid type etching solution and then washing it with water and drying by a centrifugal drying machine or the like.

The polycrystalline silicon layer has hydrophobic property and therefore, a small amount of washing liquid possibly remains on the surface thereof in the form of water drops containing undesired impurities originated from etching solution used, even if the washing is carried out with pure water. The drops of washing liquid remaining on the surface cause the deposition of impurities included in the etching liquid after the drying process. The presence of such impurities results in the extreme acceleration of the etching speed at the area in which the impurities are deposited and this tends to form an open circuit between the patterns in the worst case. On the other hand, if the area where the impurities are deposited is exclusively difficult to etch, part of the area to be removed by etching remains and this tends to form a short circuit between the patterns in the worst case.

There is, thus, a great demand for developing a novel method for treating the polycrystalline silicon layer exposed to the air, which reduces or obviates the aforementioned drawbacks.

Summary of the Invention

This invention provides a method of manufacturing a semiconductor device having a polycrystalline silicon layer.

This invention also provides a method for treating a polycrystalline silicon layer, which causes an improvement in the surface properties thereof.

This invention further provides a method of economically manufacturing a semiconductor device of high quality in a high yield.

In accordance with the present invention there is provided a method of manufacturing a _____

semiconductor device, which comprises applying a polycrystalline silicon layer on the surface of a semiconductor substrate, diffusing phosphorus or boron into the silicon layer, removing a phosphosilicate glass layer or a borosilicate glass layer formed, during the diffusion process, on the silicon layer by wet etching and then treating the surface of the silicon layer to convert the nature of the surface to hydrophilic one.

Brief Description of the Drawings

The invention is more fully explained with reference to the attached drawings in which:

Figs. 1 to 5 show illustrative sectional views and a plan view of each step of a conventional method for manufacturing a semiconductor device, respectively; and

Figs. 6 to 9 show illustrative sectional views and a plan view of each step of the method of this invention for manufacturing a semiconductor device, respectively.

Detailed Explanation of the Invention

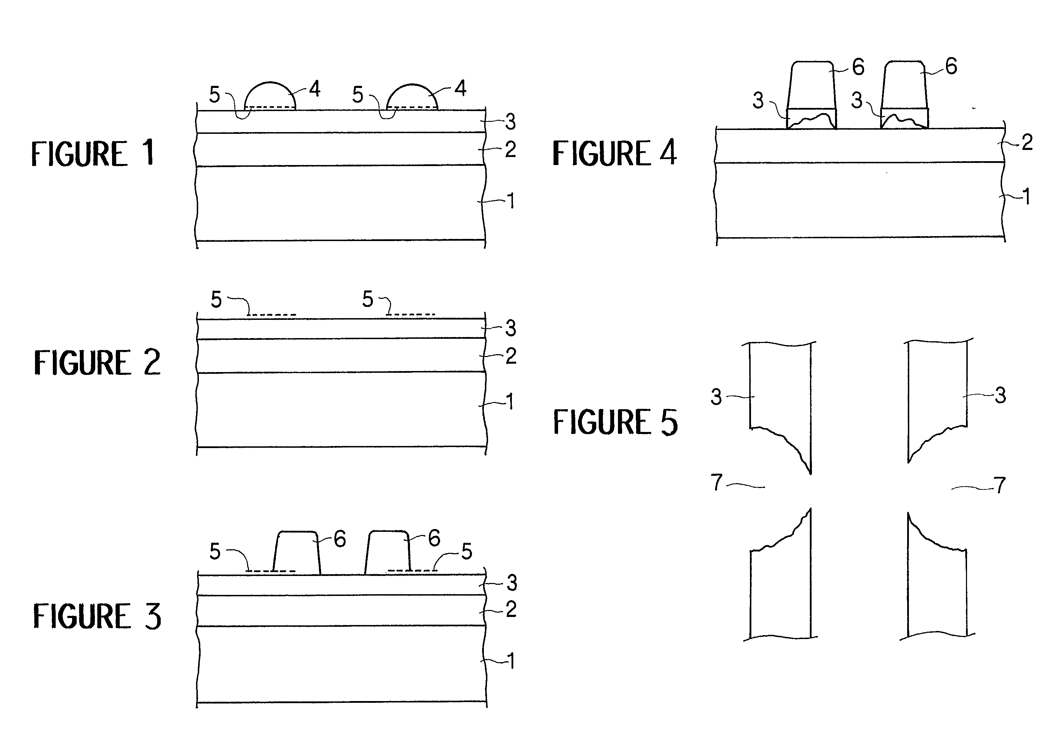

Referring to Figs. 1 to 5, the steps for preparing a semiconductor device which has a polycrystalline silicon layer, such as the polycrystalline silicon gate type FET, according to a conventional method are illustrated. In the method, an oxide layer 2 is first applied to the substrate 1 of a semiconductor (for example Si single crystal) according to any one of the known techniques such as thermal oxidation, chemical vapour deposition (CVD), sputtering, anodizing or the like. Then polycrystalline silicon layer 3 is deposited on the oxide layer 2 according to any one of known techniques such as low pressure CVD, plasma CVD, thermal decomposition of $SiH_4$ gas, hydrogen reduction of a gas mixture of $SiCl_4$ and $SiHCl_3$. The polycrystalline silicon layer 3 obtained is then subjected to the phosphorus or boron diffusion procedure to improve electrical resistance thereof. At this stage, phosphosilicate glass or borosilicate glass having a high phosphorus or boron concentration is formed at the surface of the silicon layer 3, which is insufficient in quality and should be removed according to a suitable treatment. The removal thereof is conventionally carried out by an etching technique utilizing, for example, hydrofluoric acid type etching liquid.

However, as already mentioned, the polycrystalline silicon layer is highly hydrophobic and even after washing out the etching liquid, a lot of drops 4 remain on the surface of the silicon layer 3 as shown in Fig. 1. The drops of washing liquid contain undesirable impurities derived from the etching liquid used and cause the deposition of impurities 5 (see Fig. 2) on the silicon layer 3 after drying. These impurities 5 are quite harmful to the subsequent processes such as etching. For example, as shown in Fig. 3, when the polycrystalline silicon layer 3 is subjected to patterning process according to a photoetching technique utilizing a resist 6 as the etching mask, the remaining impurities 5 tend to accelerate the etching speed extremely, or to restrict the progress of the etching substantially. Thus, the presence of such impurities results in the overetching as shown in Fig. 4, which prevents the formation of correct pattern of the polycrystalline silicon and, in turn, the correct processing of the source and/or drain region. The polycrystalline silicon layer under the resist 6 is, for example, overetched as shown in Fig. 5. That is, the pattern of the polycrystalline silicon layer suffers a deficit 7. Fig. 5 is a plane view of the article shown in Fig. 4, wherein the resist 6 is removed and only the pattern of the silicon layer 3 is shown. While, if the impurities tend to restrict the progress of the etching, the part of the silicon layer to be removed by etching remains on the oxide layer 2 as it is. This also prevent the formation of the correct pattern and the precise processing in the subsequent steps. Moreover, in the worst case, the open circuit or short circuit is formed between the patterns obtained as already mentioned.

As the etching technique for patterning the polycrystalline silicon layer, there may be mentioned, for example, any known wet etching and dry etching such as sputter etching, plasma etching, reactive ion etching.

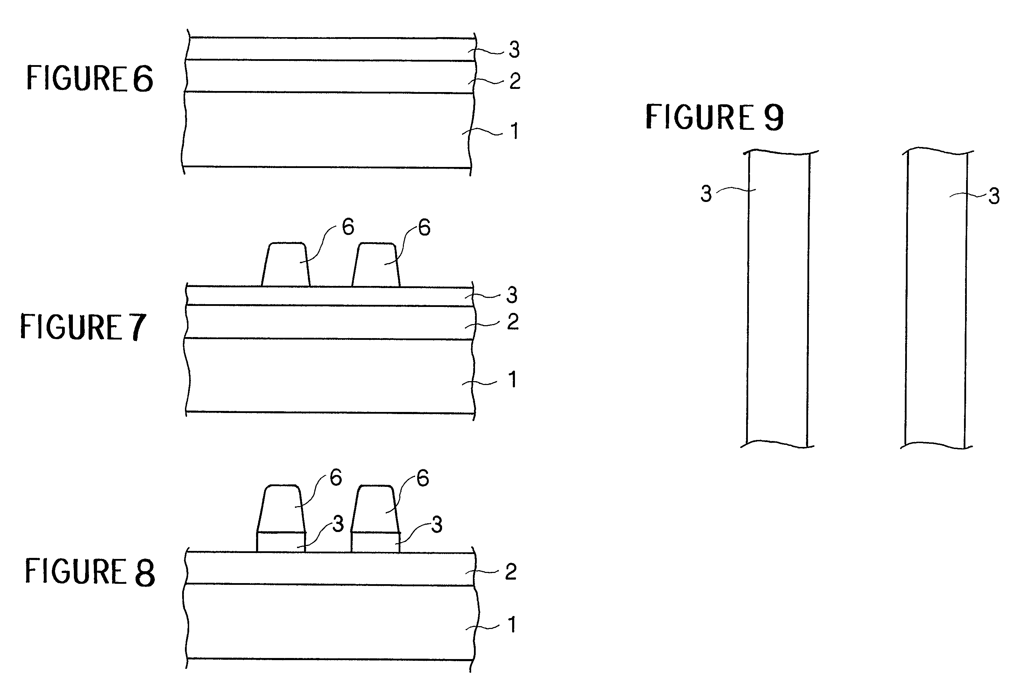

While, according to the method of this invention, the aforementioned drawbacks observed in the conventional method may be overcome by treating the polycrystalline silicon layer 3 exposed to the air after the removal of the phosphosilicate glass layer with a strong oxidizing solution to convert the surface nature of the silicon layer to a hydrophilic one. As the preferred examples of the strong oxidizing solution, there may be mentioned such solutions as an aqueous solution of nitric acid or hydrogen peroxide. The treatment is carried out by immersing or dipping the silicon layer in the strong oxidizing solution to form silanol groups on the surface thereof. The silanol groups have high compatibility to water and therefore, the water drops are not formed on the silicon layer after washing (see Fig. 6). This means, in turn, that the disadvantage of forming impurity deposits can effectively be eliminated.

In general, it is preferred to carry out the oxidizing process at a temperature of from 10 to 30°C (in the case of nitric acid which is usually used as an aqueous solution of 10 to 70wt%) or 10 to 30°C (in the case of hydrogen peroxide which is usually used as an aqueous solution of 20 to 35wt%) for 1 to 20 minutes.

In the method of the present invention, the steps other than the oxidation treatment can be carried out according to any one of the conventional methods and not restricted to a specific technique, provided that the removal of the phosphosilicate glass layer should be effected by a wet etching technique wherein a conventional etching liquid such as a mixture of $NH_4F$, HF and water or HF solution is used.

Thus, according to the method of this invention, a hydrophilic surface of the polycrystalline silicon layer can effectively be obtained, thereby the deposition of impurities, originated from the etching solution used, on the surface can almost completely be prevented during washing and drying procedures. This permits carrying out a quite precise

7

etching of the polycrystalline silicon layer and precisely forming a desired pattern on the layer (see Figs. 7 to 9). Moreover, the method of this invention improves the producibility or yield of semiconductor devices and makes it possible to manufacture them economically.

In the method of this invention, it is, of course, possible to utilize any other method for treating the surface of the silicon layer, which permits the formation of silanol groups on the silicon layer exposed to the air. Furthermore, the treatment for making the polycrystalline silicon layer hydrophilic according to the invention may be applicable to any other process comprising the steps of processing the surface of a silicon layer in particular the steps of wet etching of such silicon layer, washing and drying.

The method of this invention will now be described in more detail in the light of the following illustrative example.

Example

Phosphorus was diffused into the polycrystalline silicon layer deposited on a semiconductor substrate (Si single crystal) through an oxide layer and then the phosphosilicate glass layer formed on the surface of the silicon layer during the diffusion process was removed by immersing the layer in hydrofluoric acid type etching solution. The surface of the polycrystalline silicon layer exposed to the air after the removal of the glass layer was then immersed in 30wt% nitric acid solution for 5 minutes at room temperature to oxidize

8

the surface thereof. Owing to the oxidizing treatment, a thin oxide layer containing silanol residues was formed on the surface and the surface became hydrophilic. Thus, the formation of drops of washing liquid containing impurities and the deposition thereof on the surface were advantageously eliminated due to the presence of silanol groups on the surface and therefore the subsequent photoetching procedure is substantially improved in its dimensional accuracy.

In fact, according to the conventional method, it was found that 1 to $5/cm^2$ of defects were present on the polycrystalline silicon layer when it was etched to obtain a desired pattern. While according to the method of this invention, the defects due to patterning were limited to at most about $0.05/cm^2$.

The result clearly shows that the method of this invention is quite effective to improve the surface property of the polycrystalline silicon layer in particular its hydrophilic nature which, in turn, permits the achievement of a precise processing (patterning) of the polycrystalline silicon layer.

0171186

CLAIMS

1. A method of manufacturing a semiconductor device having a polycrystalline silicon layer comprises the steps of diffusing phosphorus or boron into the polycrystalline silicon layer deposited on the surface of a semiconductor substrate, removing a phosphosilicate glass layer or a borosilicate glass layer formed during said diffusion process by wet etching and then converting the surface of the polycrystalline silicon layer to the hydrophilic surface.

2. A method as claimed in claim 1 wherein the wet etching is carried out by immersing the glass layer in hydrofluoric acid type etching solution.

3. A method as claimed in claim 1 or claim 2 wherein the hydrophilic surface of the polycrystalline silicon layer is obtained by immersing the silicon layer in an oxidizing solution.

4. A method as claimed in claim 3 wherein the oxidizing solution is an aqueous solution of nitric acid or hydrogen peroxide.

5. A method as claimed in claim 4 wherein the strong oxidising solution is an aqueous solution of nitric acid having a concentration of 10 to 70 wt %.

6. A method as claimed in claim 4 wherein the strong oxidising solution is an aqueous solution of hydrogen peroxide having a concentration of 20 to 35 wt %.

7. A method as claimed in any one of claims 3 to 6 wherein the oxidation is carried out at a temperature of 10 to 30°C.

FIGURE 1

FIGURE 2

FIGURE 3

FIGURE 4

FIGURE 5

FIGURE 6

FIGURE 7

FIGURE 8

FIGURE 9

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-4 050 954 (BASI) * claims 1,4; column 2, lines 4-26 * | 1 | H 01 L 21/306 |
| Y | PATENT ABSTRACTS OF JAPAN, vol. 2, no. 17 (E-77), 6th February 1978, page 11066 E 77; & JP - A - 52 135 689 (FUJITSU) 11-12-1977 | 1 | |
| Y | EXTENDED ABSTRACTS, vol. 81, no. 2, October 1981, pages 995-997, Pennington, US; R. ANGELUCCI et al.: "Electrical properties of heavily arsenic or phosphorus doped polycrystalline silicon" * page 995, first two paragraphs * | 1 | |
| A | PATENT ABSTRACTS OF JAPAN, vol. 5, no. 109 (E-65)[781], 15th July 1981; & JP - A - 56 49526 (TOKYO SHIBAURA) 06-05-1981 | 4 | TECHNICAL FIELDS SEARCHED (Int. Cl.4)  C 23 G 1/00 H 01 L 21/30 |
| A | PATENT ABSTRACTS OF JAPAN, vol. 7, no. 229 (E-203)[1374], 12th October 1983; & JP - A - 58 118 121 (SUWA SEIKOSHA) 14-07-1983 | 4 | |

--- -/-

The present search report has been drawn up for all claims

| Place of search BERLIN | Date of completion of the search 03-10-1985 | Examiner GIBBS C.S. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

0171186

European Patent
Office

**EUROPEAN SEARCH REPORT**

Application number

EP  85 30 4819

| DOCUMENTS CONSIDERED TO BE RELEVANT | | | Page  2 |
|---|---|---|---|

| Category | Citation of document with indication, where appropriate, of relevant passages | Relevant to claim | CLASSIFICATION OF THE APPLICATION (Int. Cl.4) |
|---|---|---|---|
| A | JOURNAL OF THE ELECTROCHEMICAL SOCIETY, vol. 128, no. 1, January 1981, Manchester, US; T. MAKINO et al.: "Acceleration of plasma etch rate caused by alkaline residues", pages 103-106 | | |
| | ----- | | |
| | | | **TECHNICAL FIELDS SEARCHED (Int. Cl.4)** |

The present search report has been drawn up for all claims

| Place of search | Date of completion of the search | Examiner |
|---|---|---|
| BERLIN | 03-10-1985 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82